**Europäisches Patentamt**

(19) **European Patent Office**

**Office européen des brevets**

(11) Veröffentlichungsnummer: **0 124 712 B1**

(12) **EUROPÄISCHE PATENTSCHRIFT**

(45) Veröffentlichungstag der Patentschrift: **11.03.87**

(21) Anmeldenummer: **84102492.0**

(22) Anmeldetag: **08.03.84**

(51) Int. Cl.⁴: **H 05 K 7/14, H 05 K 9/00**

(54) **Plattenhalterung, insbesondere für RF-Leiterplatten, sowie ein Verfahren zu deren Herstellung.**

(30) Priorität: **25.03.83 CH 1649/83**

(43) Veröffentlichungstag der Anmeldung:
**14.11.84 Patentblatt 84/46**

(45) Bekanntmachung des Hinweises auf die Patenterteilung:
**11.03.87 Patentblatt 87/11**

(84) Benannte Vertragsstaaten:
**AT CH DE GB LI**

(56) Entgegenhaltungen:
**CH - A - 379 211**
**FR - A - 2 116 630**
**GB - A - 1 073 108**
**GB - A - 2 029 645**

(73) Patentinhaber: **BBC Aktiengesellschaft Brown, Boveri & Cie., Haselstrasse, CH-5401 Baden (CH)**

(72) Erfinder: **Hilpert, Bruno, St. Annaweg 5, D-7891 Küssaberg 2 (DE)**

(73) Patentinhaber: **BBC Aktiengesellschaft Brown, Boveri & Cie., Haselstrasse, CH-5401 Baden (CH)**

(72) Erfinder: **Hilpert, Bruno, St. Annaweg 5, D-7891 Küssaberg 2 (DE)**

## Beschreibung

Die Erfindung geht aus von einer Plattenhalterung, insbesondere für RF-Leiterplatten, gemäss dem Oberbegriff des Anspruchs 1. Eine solche Plattenhalterung ist z.B. aus der GB-A-1 073 108 bekannt.

Plattenhalterungen werden seit langem in elektronischen Geräten verwendet, in denen bestimmte Schaltungsteile, zu Baugruppen zusammengefasst, auf einer Anzahl von Leiterplatten mit gedruckten Schaltungen untergebracht und auswechselbar gehaltert werden. Die Rahmenteile, die üblicherweise aus einem isolierenden Kunststoff hergestellt sind, weisen in ihrer Längsrichtung Nute auf, die in einer Weise auf die Abmessungen der Leiterplatte abgestimmt sind, dass die Platte ohne Schwierigkeiten von der Vorderseite her eingeschoben und auch wieder herausgezogen werden kann. Quer zur Nutrichtung sind am hinteren Ende der Rahmenteile häufig Steckerleisten angebracht, in die entsprechende Vorrichtungen auf der Leiterplatte beim Einschieben automatisch eingesteckt werden und die erforderlichen elektrischen Verbindungen zu anderen Schaltungsteilen herstellen.

Während die beschriebenen Rahmenteile lediglich mechanisch wirkende Halterungen ohne eine elekrische Aufgabe darstellen, ist es im Falle von äusserst störempfindlichen oder beispielsweise Hochfrequenz-Schaltungen oftmals unerlässlich, die Leiterplatten in einem abschirmenden Metallgehäuse unterzubringen, das mit der Masseleitung der Schaltung gut leitend verbunden ist, und die Haltevorrichtungen in geeigneter Weise zu modifizieren. Insbesondere ist es jedoch bei sehr hohen Betriebsfrequenzen im GHz-Bereich zunehmend wichtig, die Gehäusegeometrie so auszulegen, dass sich im Zusammenwirken mit der Leiterplatte und ihrer Schaltung die erwünschten Hochfrequenzeigenschaften ergeben. Dies führt zum Aufbau weitgehend vorgefertigter, häufig gefräster oder aus Blechen gebogener und zusammengelöteter Gehäuse, in welche die Leiterplatten nachträglich eingesetzt und dann befestigt werden.

So ist z.B. aus der GB-A-2 029 645 bekannt, in einer HF-Schaltung die Leiterplatte innerhalb des Gehäuses in eine Halterung einzuschieben, die aus geschlitzten und umgebogenen Teilen des Gehäuseblechs besteht. Hier sind punktuelle Lötverbindungen zwischen Leiterplatte und Gehäuse vorgesehen.

Aus der eingangs genannten GB-A-1 073 108 ebenso wie aus der FR-A-2 116 630 ist nun ein Abschirmgehäuse für eine Leiterplatte bekannt, bei dem ein U-förmiger Rahmen aus leicht lötbarem Blech verwendet wird. In diesen Rahmen wird die Leiterplatte eingeschoben und beispielsweise schwallverlötet.

Der vorliegenden Erfindung liegt daher die Aufgabe zugrunde, eine Plattenhalterung zu schaffen, die gleichermassen den einfachen Aufbau einer vollständigen Abschirmung ermöglicht, eine sehr gute und beständige elektrische sowie mechanische Verbindung zwischen Schaltung und Abschirmgehäuse herzustellen gestattet und ohne grossen Aufwand realisiert werden kann.

Die Aufgabe wird bei einer Plattenhalterung der eingangs genannten Art durch die Merkmale aus dem kennzeichnenden Teil des Anspruchs 1 gelöst.

Die erfindungsgemässe Plattenhalterung hat den Vorteil, dass sie eine mechanisch und elektrisch sichere Verbindung zwischen der Platte und den Rahmenteilen aufweist, durch entsprechende obere und untere Abdeckplatte ohne Probleme zu einem hochfrequenzdichten Abschirmgehäuse erweitert werden kann und mit Hilfe der Lötkanäle in einfacher und für eine automatisierte Fertigung geeigneter Weise hergestellt werden kann.

Bei dem Verfahren zur Herstellung der erfindungsgemässen Plattenhalterung wird die Platte mit ihren Rändern zunächst in die Nute der mit den Lötkanälen versehenen Rahmenteile eingeschoben. Dann wird ein geeignetes Lot von oben in die Lötkanäle eingefüllt. Danach werden die Rahmenteile auf eine Temperatur oberhalb der Schmelztemperatur des verwendeten Lotes erhitzt und solange oberhalb der Schmelztemperatur gehalten, bis das nun flüssige Lot aus den Lötkanälen beidseitig zwischen die Plattenränder und die Nutinnenflächen geflossen ist und sich dort verteilt hat. Schliesslich wird durch Abkühlen eine feste Lötverbindung zwischen der Platte und den Rahmenteilen hergestellt.

Nachfolgend soll nun die Erfindung in Ausführungsbeispielen anhand der Zeichnung beschrieben und näher erläutert werden.

Es zeigen:

Fig. 1 eine Plattenhalterung nach der Erfindung in Draufsicht,

Fig. 2 den Querschnitt durch eine Plattenhalterung nach Fig. 1 in der mit A-A bezeichneten Ebene aus Fig. 1,

Fig. 3 den vergrösserten Querschnitt durch ein Rahmenteil und den zugeordneten Plattenrand vor dem Einschieben der Platten in die Nut,

Fig. 4 eine mit Abdeckplatten komplettierte Plattenhalterung mit einer innenliegenden und abgeschirmten, elektronischen Schaltung, und

Fig. 5 im Querschnitt eine bevorzugte Anordnung zum Herstellen der Lötverbindung.

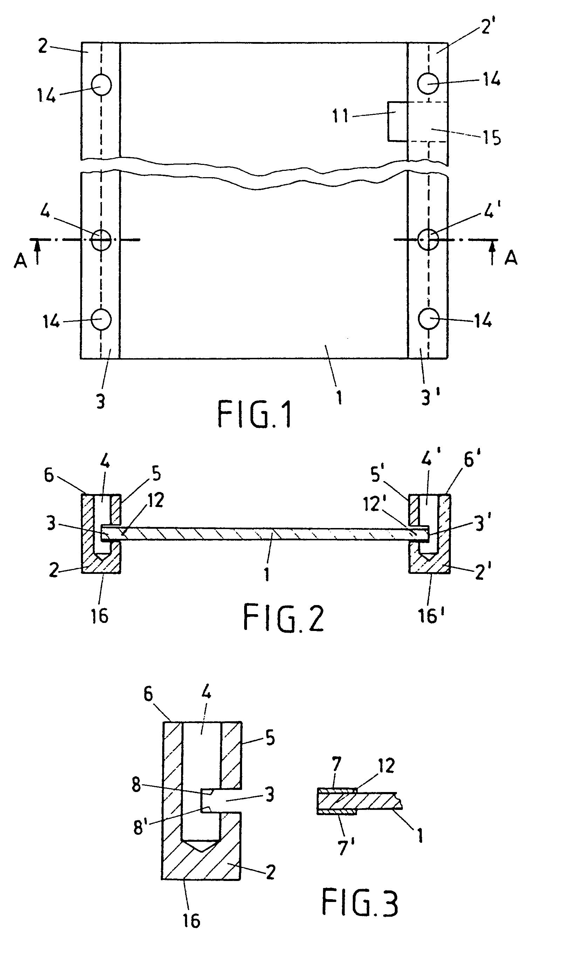

In Fig. 1 ist eine erfindungsgemässe Plattenhalterung in der Draufsicht dargestellt. Eine Platte 1, beispielsweise eine beidseitig mit Leiterbahnen versehene Teflon- oder Polyäthersulfonplatte ist zwischen zwei länglichen und stabförmigen Rahmenteilen 2 und 2' angeordnet und mit den gegenüberliegenden Rändern in entsprechende Nute 3 und 3' eingeschoben, deren Tiefe durch die gestrichelten Linien innerhalb der Rahmenteile 2, 2' angedeutet ist. Von der Oberseite der Rahmenteile 2, 2' her verlaufen Lötkanäle 4 und 4' zu den darunterliegenden Nuten 3, 3' hin und verbinden diese dadurch mit dem Aussenraum. Weiterhin können neben diesen Lötkanälen 4, 4' verschiedenartige Befestigungslöcher 14 in den Rahmenteilen 2, 2' vorgesehen werden, die in Form durchgehender Bohrungen oder Gewindelöcher dazu dienen, die Rahmenteile 2, 2' mit einer Unterlage und/oder Abdeckplatten zu verbinden. Weiterhin ist es möglich, am Rand der Platte Aussparungen 11 freizulassen, die in Verbindung mit einer entsprechenden Durchgangsbohrung 15 durch das Rahmenteil 2' Raum für von aussen bedienbare Schaltungselemente, z.B. Trimmer, oder Stromzuführungen über Durchführungskondensatoren geben.

Fig. 2 zeigt den Querschnitt durch eine Plattenhalterung nach Fig. 1 in einer durch die Linie A–A in Fig. 1 gekennzeichneten Ebene. Die Rahmenteile 2, 2' haben typischerweise einen prismatischen Querschnitt. Die Nuten 3, 3' verlaufen in Längsrichtung auf den Rahmeninnenseiten 5, 5' und haben eine Tiefe von mehreren Millimetern, die einerseits ausreicht, um der Platte 1 genügend Halt zu geben, und andererseits nicht eine unnötig grosse Fläche von der Platte 1 in Anspruch nimmt. Wenn die Platte 1 eine doppelseitig bedruckte Leiterplatte ist, die von der Ober- und Unterseite her mit elektronischen Bauelementen einer gewissen Bauhöhe bestückt wird, ist es zweckmässig, dass die Nuten 3 und 3' im Mittelbereich der Rahmeninnenseiten 5, 5' verlaufen, um auf beiden Seiten der Platte im komplettierten Abschirmgehäuse ausreichend Platz zu gewinnen.

Von den Rahmenoberseiten 6, 6' her reichen die Lötkanäle 4, 4' wenigstens bis zu den Nuten 3, 3', sind aber zu den Rahmenunterseiten 16 und 16' hin geschlossen, damit beim Lötvorgang das flüssige Lot zwar aus den Lötkanälen 4, 4' in die Nute 3, 3' hinein, nicht jedoch nach unten herausfliessen kann. Für eine Serienfertigung der Rahmenteile 2, 2' ist es vorteilhaft, die Lötkanäle 4, 4' als zur Platte 1 senkrechte Sacklöcher auszuführen, die in ihrer Tiefe durch die Nute 3, 3' hindurchreichen, wenn die Lötung beidseitig erfolgen soll, und mit ihren Mittelachsen bezüglich der Nuttiefe dergestalt angeordnet sind, dass sie von den Nuten lediglich teilweise angeschnitten werden. Solche Sacklöcher sind mittels Bohrautomaten sehr einfach herzustellen. Insbesondere wird aber durch ihre Anordnung erreicht, dass das in den Lötkanälen 4, 4' befindliche, aufgeschmolzene Lot während des Lötvorganges ungehindert um die Plattenkanten herum die Plattenränder 12, 12' in den Nuten 3, 3' von beiden Seiten benetzen kann. Auf diese Weise kann in einem Arbeitsgang die beidseitige Lötung zwischen der Platte 1 und den Rahmenteilen 2, 2' durchgeführt werden. Die Lötung erstreckt sich dabei üblicherweise über die gesamte Länge der Rahmenteile 2, 2', um so einen geschlossenen mechanischen und elektrischen Übergang zwischen ihnen und der Platte 1 zu ermöglichen.

In bestimmten Fällen ist es jedoch vorteilhaft, eine Aussparung 11 am Rand der Platte vorzusehen, wie sie in Fig. 1 eingezeichnet ist. In dieser Aussparung 11 kann beispielsweise liegend ein Trimmer angeordnet werden, der durch Leiterbahnen auf der Platte 1 mit der Schaltung verbunden ist. Da eine solche Aussparung 11 die durchgehende Verlötung des Plattenrandes 12' unterbricht, müssen in diesem Fall auf beiden Seiten der Aussparung 11 Lötkanäle vorgesehen werden, um auf beiden Seiten das für den Lötvorgang erforderliche Lot zuzuführen.

Für die Qualität der Lötung und insbesondere für gute HF- bzw. Abschirmeigenschaften der Rahmenteile 2, 2' und der mit ihnen verbundenen Abdeckplatten ist es wünschenswert, wenn die Rahmenteile 2, 2' eine Oberfläche besitzen, die eine hervorragende Lötfähigkeit mit einer ausgezeichneten elektrischen Leitfähigkeit kombiniert. Dies wird sehr vorteilhaft und zugleich wirtschaftlich dadurch erreicht, dass die Rahmenteile massiv aus einem preisgünstigen Metall, z.B. Messing, gefertigt sind und eine versilberte Oberfläche aufweisen. Gleichzeitig wird dann auch zweckmässigerweise die Lötverbindung durch ein mit Silber gesättigtes Lot vermittelt, wodurch verhindert wird, dass während des Lötvorganges Silber aus der Oberflächenschicht der Rahmenteile in Lösung geht und die Qualität der Lötstelle beeinträchtigt.

Die Verteilung des flüssigen Lotes aus den Lötkanälen 4, 4' in die zwischen den Nuten 3, 3' und den Plattenrändern 12, 12' gebildeten, spaltförmigen Räume auf beiden Seiten der Plattenränder erfolgt durch kapillare Kräfte und hängt daher eng mit den geometrischen Abmessungen dieser Räume zusammen. Damit die Kapillarkräfte wirksam werden, aber auch die Menge des benötigten Lotes gering gehalten wird, ist es vorteilhaft, dass die Breite der Nute 3, 3' die Dicke der in ihnen liegenden Plattenränder 12, 12' nur um weniger als 0,2 mm übersteigt. Beträgt die Dicke also beispielsweise 1,6 mm, so werden mit einer Nutbreite von 1,7 mm ausgezeichnete Ergebnisse im Bezug auf die Lötverbindung erhalten. Je nach der Vorbehandlung der zu lötenden Flächen, den Fliesseigenschaften des verwendeten Lotes und der geometrischen Abmessungen von Rahmenteilen 2, 2' und Platte 1 richtet sich die geeignete Verteilung der verschiedenen Lötkanäle entlang der Rahmenteile. Dringt das Lot aus einem Lötkanal nur wenige Millimeter seitwärts in die Spalte zwischen Rahmenteil und Plattenrand vor, müssen die Lötkanäle in einer entsprechend dichteren Abfolge vorgesehen werden, als wenn der maximale Ausbreitungsweg mehrere Zentimeter beträgt. Bei Rahmenteilen mit versilberter Oberfläche und einer Nuttiefe von etwa 2,5 mm und bei Verwendung eines üblichen Weichlots haben sich Abstände zwischen benachbarten Lötkanälen von 10–30 mm bewährt.

In Fig. 3 ist in vergrössertem Massstab der Querschnitt durch ein Rahmenteil 2 und den Randteil der Platte 1 vor dem Zusammenbau dargestellt. Für die Lötung werden die Nutinnenflächen 8 und 8' benutzt, denen im eingeschobenen Zustand Randoberflächen 7 und 7' gegenüberliegen. Im Falle einer üblichen Leiterplatte handelt es sich bei diesen Randoberflächen 7, 7' um Kupferschichten mit einer Breite, die wenigstens annähernd so gross wie die Nuttiefe ist und einer Oberfläche, die zur Verbesserung der Lötfähigkeit vorbehandelt, also z.B. vorverzinnt sein kann. Besonders vorteilhaft ist es, wenn die Randoberflächen 7, 7' etwas breiter als die Nuttiefe sind, weil dann nach dem Lötvorgang die Qualität der Lötung anhand des sichtbaren Lötstreifens optisch kontrolliert werden kann. Die Randoberflächen 7, 7' sind ein Teil des auf die Platte gedruckten Leitungssystems und stellen die elektrische Verbindung zwischen der Schaltung und dem Rahmenteil 2 her.

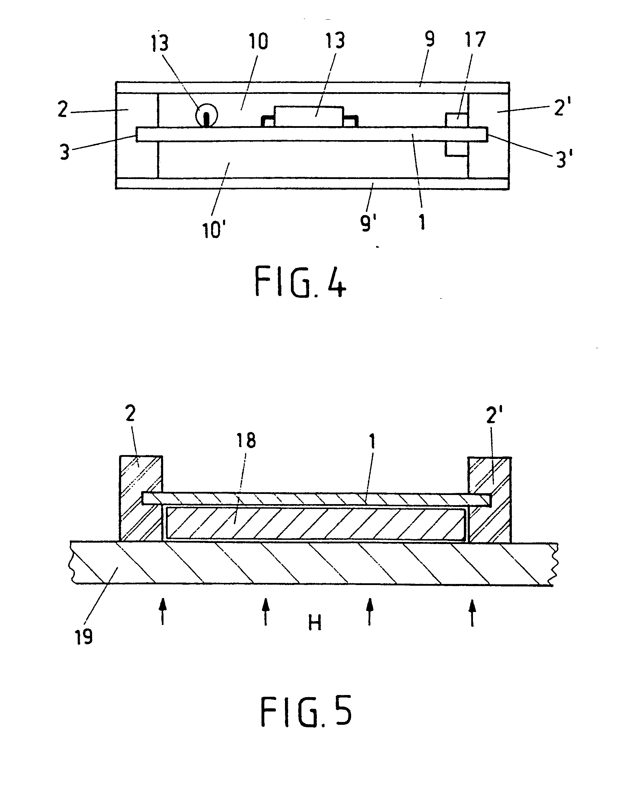

Die Abschirmung der Schaltung wird nach der in Fig. 4 gezeigten Art vervollständigt. Nach oben und unten wird das Abschirmgehäuse durch elektrisch leitende Abdeckplatten 9 und 9' abgeschlossen, die an den Rahmenteilen 2 und 2' mit gutem elektrischen Kontakt anliegen und an ihnen befestigt sind. Die untere Abdeckplatte 9' kann aber auch dadurch ersetzt werden, dass die Rahmenteile 2 und 2', mit der velöteten Platte 1 dazwischen, auf eine grössere, leitende Trägerplatte aufgeschraubt sind, die den unteren Teil der Abschirmung übernimmt und daneben noch andere Plattenhalterungen der gleichen Art trägt. Die Querseiten lassen sich zusammen mit der offenen Oberseite abdecken, wenn eine obere Abdeckplatte 9 mit abgewinkelten und angepassten Seitenflächen verwendet wird.

Die in Fig. 4 dargestellte Anordnung von drei parallelen Platten 9, 1 und 9', von denen die mittlere Platte 1 eine Schaltung mit elektronischen Bauelementen 13 und gegebenfalls von aussen bedienbare Trimmer 17 trägt, bildet zwei Hohlräume 10 und 10', die sich vorteilhaft zum Aufbau von Schaltungselementen, insbesondere Induktivitäten und Kapazitäten für Höchstfrequenz-Anwendungen im GHz-Bereich einsetzen lassen. Durch entsprechend gestaltete Leiterflächen auf beiden Seiten der Platte 1, die den leitenden Abdeckplatten gegenüberliegen, können z. B. zusammen mit den Abdeckplatten Resonanzelemente aufgebaut werden, die aufgrund des festen mechanischen Aufbaus der Plattenhalterung in ihrer Geometrie festliegen und reproduzierbare elektrische Eigenschaften besitzen.

Bei der Herstellung der Plattenhalterung wird nach dem Einschieben der normalerweise unbestückten Platte 1 mit ihren Plattenrändern 12 und 12' in die Nute 3, 3' der Rahmenteile 2 und 2' das Lot in die Lötkanäle 4, 4' eingefüllt. Dies kann in einer Weise geschehen, dass Stücke eines Lötdrahtes in der erforderlichen Länge und mit einem Durchmesser nicht viel kleiner als der des Lötkanals, in den Lötkanal eingeführt werden. Beim Erhitzten erfüllt dann das geschmolzene Lot den Lötkanal und breitet sich längs der Nute vom Lötkanal her seitwärts aus. Um die Benetzung der Nutinnenflächen 8 und 8' durch das Lot zu verbessern, ist es vorteilhaft, die Nute 3, 3' vorher mit einem zum verwendeten Lot passenden Flussmittel zu behandeln, wie dies dem Fachmann an sich bekannt ist. Für die automatisierte Fertigung besonders günstig ist es aber auch, das Lot zusammen mit einem Flussmittel in Form einer fein vermischten, cremeartigen Lötpaste einzufüllen. Eine solche Paste lässt sich mittels einer Dosiermaschine in genau der erforderlichen Menge in die Lötkanäle eingeben, wobei die feine Verteilung des Flussmittels das Fliessen und Benetzen

des Lotes in den schmalen Spalten zwischen Rahmenteil und Plattenrand fördert. Gute Ergebnisse wurde mit einem niedrigschmelzenden Lot erzielt, das eine Schmelztemperatur von ungefähr 180°C hatte.

Nachdem das Lot in die Lötkanäle eingefüllt ist, werden die Rahmenteile soweit erhitzt, bis das Lot in den Lötkanälen schmilzt und in die Nuten einfliesst. Damit der Fliessvorgang nicht durch eine stark unterschiedliche Temperaturverteilung in den Rahmenteilen 2, 2' beeinträchtigt wird, sollte die Erwärmung möglichst gleichmässig über die gesamte Rahmenlänge erfolgen. Dies kann mit einer Lötanordnung erreicht werden, wie sie in Fig. 5 wiedergegeben ist. Die Rahmenteile 2, 2' mit der eingeschobenen Platte 1 werden auf eine gut wärmeleitende und unter Wärmeeinwirkung formbeständige, ebene Unterlage 19 gebracht, die von ihrer Unterseite her mit der nötigen Hitze H geheizt wird und aufgrund ihrer guten Wärmeleitfähigkeit die Temperatur gleichmässig verteilt. Zusätzlich ist es von Vorteil, die Platte 1 mit einer wärmebeständigen und wärmeisolierenden Zwischenlage 18, die zwischen Platte 1 und Unterlage 19 angeordnet ist, vor der Wärmestrahlung und -konvektion der Unterlage 19 zu schützen. Für die automatische Fertigung ist es auch günstig, wenn die Rahmenteile 2 und 2' für den Lötvorgang durch einen im wesentlichen parallel zu den Nuten 3, 3' fliessenden, starken Strom erhitzt werden, der mittels an den Enden angebrachter elektrischer Kontakte durch die Rahmenteile geleitet wird. Insgesamt erweist sich eine Plattenhalterung gemäss der Erfindung als eine mechanisch stabile und elektrisch zuverlässige Anordnung für eine Leiterplatte, die einerseits eine gute Masseverbindung benötigt und andererseits ausreichend abgeschirmt werden muss. Ein besonderer Vorteil der Halterung liegt darin, dass ihre Herstellung in einfacher Weise automatisch erfolgen kann.

**Patentansprüche**

1. Plattenhalterung, insbesondere für RF-Leiterplatten, mit wenigstens einem Rahmenteil (2, 2') und einer an das Rahmenteil (2, 2') angrenzenden Platte (1), die mit einem Plattenrand (12, 12') in eine entsprechende, auf der Rahmeninnenseite (5, 5') in Längsrichtung verlaufende Nut (3, 3') des Rahmenteils (2, 2') eingeschoben ist, wobei das Rahmenteil (2, 2') aus einem Metall ist, der Plattenrand (12, 12') wenigstens eine lötbare, metallische Randoberfläche (7, 7') aufweist, und der Plattenrand (12, 12') über die Randoberfläche (7, 7') mit einer entsprechenden Nutinnenfläche (8, 8') der Nut (3, 3') verlötet ist, dadurch gekennzeichnet, dass die Nut (3, 3') innerhalb des Rahmenteils (2, 2') durch jeweils wenigstens einen Lötkanal (4, 4') zu der Rahmenoberseite (6, 6') hin mit dem Aussenraum verbunden ist.

2. Plattenhalterung nach Anspruch 1, dadurch gekennzeichnet, dass die Lötkanäle (4, 4') als zur Platte (1) senkrechte Sacklöcher ausgeführt sind und von der Nut (3, 3') teilweise angeschnitten werden.

3. Plattenhalterung nach Anspruch 2, dadurch gekennzeichnet, dass der Plattenrand (12, 12') beidseitig eine lötbare metallische Randoberfläche (7, 7') aufweist und die Lötkanäle (4, 4') durch die Nut (3, 3') hindurchreichen.

4. Plattenhalterung nach einem der Ansprüche 1 bis 3, dadurch gekennzeichnet, dass das Rahmenteil (2, 2') eine versilberte Oberfläche aufweist und die Lötverbindung zwischen der Platte (1) und dem Rahmenteil durch ein mit Silber gesättigtes Lot vermittelt wird.

5. Plattenhalterung nach Anspruch 1, dadurch gekennzeichnet, dass die Breite der Nut (3, 3') die Dicke des Plattenrandes (12, 12') um weniger als 0,2 mm übersteigt.

6. Verfahren zur Herstellung einer Plattenhalterung nach Anspruch 1, dadurch gekennzeichnet, dass
– die Platte (1) mit ihrem Plattenrand (12, 12') in die Nut (3, 3') des mit den Lötkanälen (4, 4') versehenen Rahmenteils (2, 2') eingeschoben wird,
– ein Lot in die Lötkanäle (4, 4') eingefüllt wird,
– das Rahmenteil (2, 2') auf eine Temperatur oberhalb der Schmelztemperatur des Lotes erhitzt und solange oberhalb dieser Schmelztemperatur gehalten wird, bis das Lot aus den Lötkanälen (4, 4') zwischen den Plattenrand (12, 12') und die Nutinnenfläche (8, 8') geflossen ist und sich dort verteilt hat, und
– durch Abkühlen eine feste Lötverbindung zwischen der Platte (1) und dem Rahmenteil (2, 2') hergestellt wird.

7. Verfahren nach Anspruch 6, dadurch gekennzeichnet, dass das Lot zussammen mit einem Flussmittel in Form einer Lötpaste in die Lötkanäle (4, 4') eingefüllt wird.

8. Verfahren nach einem der Ansprüche 6 und 7, dadurch gekennzeichnet, dass als Lot ein Weichlot mit einer Schmelztemperatur von etwa 180°C verwendet wird.

9. Verfahren nach einem der Ansprüche 6 bis 8, dadurch gekennzeichnet, dass das Rahmenteil (2, 2') mit der eingeschobenen Platte (1) zum Erhitzen auf eine gleichmässig heizbare und ebene Unterlage gelegt wird.

10. Verfahren nach einem der Ansprüche 6 bis 8, dadurch gekennzeichnet, dass das Rahmenteil (2, 2') für den Lötvorgang durch einen im wesentlichen parallel zu der Nut (3, 3') fliessenden, elektrischen Strom erhitzt wird.

**Claims**

1. Board retainer, particularly for RF circuit boards, comprising at least one frame part (2, 2') and a board (1) which adjoins the frame part (2, 2') and which is inserted with one board edge (12, 12') into a corresponding groove (3, 3'), extending in the longitudinal direction along the inside (5, 5') of the frame, of the frame part (2, 2'), in which arrangement the frame part (2, 2') is of a metal, the board edge (12, 12') has at least one solderable, metallic edge surface (7, 7') and the board edge (12, 12') is soldered via the edge surface (7, 7') to a corresponding inner surface (8, 8') of the groove (3, 3'), characterized in that the groove (3, 3') is connected, within the frame part (2, 2'), to the outside space by in each case at least one soldering duct (4, 4') towards the top (6, 6') of the frame.

2. Board retainer according to Claim 1, characterized in that the soldering ducts (4, 4') are constructed as blind holes which are perpendicular to the board (1) and are partially intersected by the groove (3, 3').

3. Board retainer according to Claim 2, characterized in that the board edge (12, 12') has a solderable metallic edge surface (7, 7') on both sides and the soldering ducts (4, 4') penetrate through the groove (3, 3').

4. Board retainer according to one of Claims 1 to 3, characterized in that the frame part (2, 2') has a silver-plated surface and the soldering connection between the board (1) and the frame part is made by a solder saturated with silver.

5. Board retainer according to Claim 1, characterized in that the width of the groove (3, 3') exceeds the thickness of the board edge (12, 12') by less than 0.2 m.

6. Method for producing a board retainer according to Claim 1, characterized in that
– the board (1) is iserted wirh its board edge (12, 12') into the groove (3, 3') of the frame part (2, 2') provided with soldering ducts (4, 4'),
– a solder is filled into the soldering ducts (4, 4'),
– the frame part (2, 2') is heated to a temperature above the melting temperature of the solder and is kept above this melting temperature until the solder and has flowed from the soldering ducts (4, 4') between the board edge (12, 12') and the inner grooved surface (8, 8') and has become distributed there, and
– a permanent soldered connection is established between the board (1) and the frame part (2, 2') by cooling.

7. Method according to Claim 6, characterized in that the solder is filled together with a flux agent in the form of a soldering paste into the soldering ducts (4, 4').

8. Method according to one of Claims 6 and 7, characterized in that a soft solder having a melting temperature of about 180°C is used as solder.

9. Method according to one of Claims 6 to 8, characterized in that, to be heated, the frame part (2, 2') and the inserted board (1), are placed on a uniformly heatable and level support.

10. Method according to one of Claims 6 to 8, characterized in that, for the soldering process, the frame part (2, 2') is heated by an electric current flowing essentially parallel to the groove (3, 3').

**Revendications**

1. Support de plaques, en particulier pour plaques à circuit RF, comportant au moins un élément de bordure (2, 2') et une plaque (1) adjacente à l'élément de bordure (2, 2'), qui est glissée par un bord de plaque (12, 12') dans une rainure (3, 3') de l'élément de bordure (2, 2') ménagée dans le sens longitudinal dans le côté intérieur (5, 5') de l'élément de bordure, l'élément de bordure (2, 2') étant en métal, le bord de plaque (12, 12') présentant au moins une surface marginale métallique pouvant être brasée (7, 7') et le bord de plaque (12, 12') étant brasé par l'intermédiaire de la surface marginale (7, 7') à une surface interne correspondante (8, 8') de la rainure (3, 3'), caractérisé en ce que la rainure (3, 3') présente à l'intérieur de l'élément de bordure (2, 2') communique chaque fois par au moins un canal de brasage (4, 4') allant vers la surface supérieure (6, 6') de l'élement de bordure, avec l'extérieur.

2. Support de plaques suivant la revendication 1, caractérisé en ce que les canaux de brasage (4, 4') ont la forme de forures borgnes perpendiculaires à la plaque (1) et sont partiellement entaillées par la rainure (3, 3').

3. Support de plaques suivant la revendication 2, caractérisé en ce que le bord de plaque (12, 12') présente des deux côtés une surface marginale métallique pouvant être brasée (7, 7') et les canaux de brasage (4, 4') traversent la rainure (3, 3').

4. Support de plaques suivant l'une quelconque des revendications 1 à 3, caractérisé en ce que l'élément de bordure (2, 2') présente une surface argentée et la jonction brasée entre la plaque (1) et l'élément de bordure est réalisée au moyen d'une brasure saturée en argent.

5. Support de plaques suivant la revendication 1, caractérisé en ce que la largeur de la rainure (3, 3') est supérieure de moins de 0,2 mm à l'épaisseur du bord de plaque (12, 12').

6. Procédé pour fabriquer un support de plaque suivant la revendication 1, caractérisé en ce que
– la plaque (1) est glissée par son bord de plaque (12, 12') dans la rainure (3, 3') de l'élément de bordure (2, 2') pourvu des canaux de brasage (4, 4'),
– les canaux de brasage (4, 4') sont remplis au moyen d'une brasure,
– l'élément de bordure (2, 2') est chauffé à une température supérieure à la température de fusion de la brasure et est maintenu au-dessus de cette température de fusion jusqu'à ce que la brasure ait coulé hors des canaux de brasage (4, 4') entre le bord de plaque (12, 12') et la surface interne (8, 8') de la rainure et se soit répartie en cet endroit, et
– par refroidissement, une jonction brasée solide est établie entre la plaque (1) et l'élément de bordure (2, 2').

7. Procédé suivant la revendication 6, caractérisé en ce que les canaux de brasage (4, 4') sont remplis de brasure additionnée d'un fondant ayant la forme d'une pâte à braser.

8. Procédé suivant l'une ou l'autre des revendications 6 et 7, caractérisé en ce qu'à titre de brasure, on utilise une brasure tendre présentant une température de fusion d'environ 180°C.

9. Procédé suivant l'une quelconque des revendications 6 à 8, caractérisé en ce qu'en vue du chauffage, l'élément de bordure (2, 2') est posé, avec la plaque (1) glissée en place, sur une base plane pouvant être chauffée de manière uniforme.

10. Procédé suivant l'une quelconque des revendications 6 à 8, caractérisé en ce que l'élément de bordure (2, 2') est chauffé pour l'opération de brasage par un courant électrique passant en substance parallèlement à la rainure (3, 3').

FIG.1

FIG.2

FIG.3

FIG.4

FIG.5